# EUROPEAN PATENT SPECIFICATION

(11) **EP 0 375 851 B1**
(45) Date of publication and mention of the grant of the patent: **23.08.1995**
(21) Application number: 89118314.7
(22) Date of filing: 03.10.1989
(51) Int. Cl.: H01B 3/00

(54) **Encapsulated electrical or electronic device**
Verkapselte elektrische oder elektronische Einrichtung
Dispositif électrique ou électronique encapsulé

(30) Priority: 03.10.1988 US 251772
(43) Date of publication of application: 04.07.1990
(73) Proprietor: E.I. DU PONT DE NEMOURS AND COMPANY, Wilmington Delaware 19898 (US)
(72) Inventor: Sheer, M. Lana, Kennett Square Pennsylvania 19348 (US); Solenberger, John C., Wilmington Delaware 19806 (US)
(74) Representative: Abitz, Walter, Dr.-Ing.

(56) References cited:
- EP-A- 0 135 310
- EP-A- 0 206 254
- EP-A- 0 257 466
- WO-A-86/00629
- DE-A- 2 533 416
- FR-A- 2 003 774
- US-A- 3 030 597
- US-A- 4 138 525
- US-A- 4 632 798
- RESEARCH DISCLOSURE, no. 288, April 1988, page 221, abstract no. 28847, NewYork, NY, US; "Electrical resistive, thermally conductive diamond coating forintegrated circuit chips"

## Description

### Background of the Invention

This invention relates to encapsulated electrical and electronic devices and, more particularly, it relates to electrical and electronic devices encapsulated with both an insulating material and a thermally conductive material.

Specific techniques for encapsulating electrical and electronic devices are known as disclosed by Eickman et al. in U.S. -A- 4,632,798. They also disclose that it is common practice to include, within the encapsulating resin, particulate filler material such as silica or alumina which serves to increase the thermal conductivity.

The market segments for electrical devices such as for windings of motors, transformers and solenoids and electronic devices such as microchips are increasingly moving to miniaturization of such devices. This in turn leads to a rise in internal equipment operating temperature resulting in not only a need for higher temperature ratings on insulation materials used for these applications, but also a need for materials with improved thermal conductivity properties to rapidly remove the heat generated.

### Summary of the Invention

In order to complement the move toward miniaturization of such electrical and electronic devices, an article of manufacture has been developed which comprises an electrical device encapsulated with an electrically insulating material that in turn is encapsulated with a thermal conductive material forming an outer surface of the article. The thermal conductive material comprises 10 to 70% by weight and preferably from about 15 to about 60% carbon fiber, the balance being made up of a resin or a combination of a resin and an alternate fiber or filler.

Suitable resinous materials which may be used as the resin include, but are not limited to, polyethylene terephthalate, Teflon® PFA by E. I. du Pont de Nemours and Company (Du Pont), amorphous copolyamides as described in U.S. -A- 4,681,411, and Hytrel® 7246 by Du Pont as well as thermosetting resins.

The carbon fibers are centrifugally spun from mesophase pitch as disclosed in EP-A-0 306 033 (U.S. Patent Application No. 092,217 filed September 2, 1987 ).

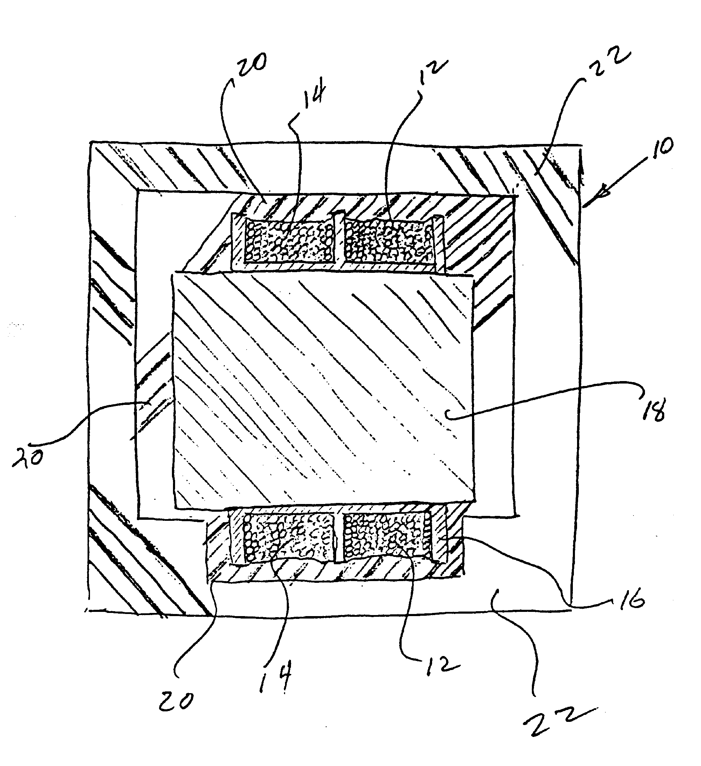

### Brief Description of the Drawing

The drawing is a schematic cross-sectional view of a transformer according to the invention.

### Detailed Description of the Illustrated Embodiment

The embodiment chosen for purpose of illustration is an article of manufacture generally designated 10 that includes an electrical device consisting of a plurality of electrically active wire coils 12, 14 wrapped around a coil form 16 positioned on a metal core 18. The coils 12, 14 serve as the primary and secondary windings of a transformer with connections leading to external terminals (not shown). Surrounding the electrical device is an encapsulating layer 20 of an electrically insulating material which in turn is encapsulated with a thermal conductive layer 22 which serves as a case for the transformer.

The thermally conductive layer 22 exhibits a three dimensional arrangement of fibers within the resin matrix as estimated from shrinkage data in the x, y, and z coordinate axes directions from mold size to the final part. More particularly, essentially equal shrinkage of the final part in the x, y, and z directions indicates three dimensional isotropic fiber reinforcement while shrinkage of the final part that varies by several orders of magnitude between directions suggests highly oriented reinforcing fibers.

### Example

In step I, a non-encapsulated transformer is introduced into a steel injection molding tool held in a standard injection molding machine. The cavity of the injection molding tool has (1) notches cut into them so as to allow the transformer leads to protrude from the cavity holding the transformer and (2) positioning pins to hold the transformer in place so that the injected polymer can flow completely around the transformer. A commercial grade Du Pont Rynite® FR-530 NC-10 polymer which is a 30 wt.% chopped glass fiber reinforced flame retarded polyethylene terephthlate polymer is heated to a melt temperature of 280°C and injected into the closed steel mold containing the transformer. After two minutes, the transformer is removed from the original steel mold. In step II, a second steel mold with similar notches and positioning pins having approximately 1,27 cm (1/2˝) to 1,9 cm (3/4˝) larger overall inner dimensions than the first mold replaces the first mold in the injection molding machine. A 50 wt. % pitch carbon mat fiber reinforced flame-retarded polyethylene terephthalate polymer made by compression molding alternate layers of flame retarded polyethylene terephthalate polymer film and carbon fiber bats made according to the disclosure in EP-A-0 306 033 which is subsequently chopped into 0,635 cm (1/4˝) pellets and fed to the injection molding machine where it is heated to 280°C and injected into the tool cavity containing the previously encapsulated transformer of step I. This doubly encapsulated transformer is removed from the mold after 1 minute and 40 seconds. A two shot encapsulated transformer was tested for electrical insulation properties of the inner layer and thermal conductivity properties of the outer layer, according to the Underwriters Laboratories standard UL 1585, sections 28, Rated Secondary Current Test, and 29, Rated Output Heating Test, and the temperature rise of 42°C was much less than the specified maximum temperature specified in the UL 1585 standard. The integrity of the electrical insulation was maintained.

## Claims

1. An improved article of manufacture comprising: an electrical device having electrically active components, said components being encapsulated with a first layer 20 of an electrically insulating material, and a second layer 22 of a thermally conductive material forming the outer surface of said article, said second layer comprising a resin reinforced with a three dimensional arrangement of carbon fibers, said carbon fibers being centrifugally spun mesophase pitch based carbon fibers and having a lamellar structure, a cross-sectional widths of from 2 to 12 micrometers and lengths above 10 mm.

2. The article as defined in claim 1 wherein said electrical device is encapsulated by means of a two-step injection molding process, said resin being thermoplastic.

## Patentansprüche

1. Verbesserter Fabrikationsgegenstand, umfassend: eine elektrische Vorrichtung mit elektrisch aktiven Komponenten, wobei die genannten Komponenten mit einer ersten Schicht 20 aus einem elektrisch isolierenden Material und einer zweiten Schicht 22 aus einem thermisch leitenden Material, welche die äußere Oberfläche des genannten Gegenstands bildet, eingekapselt sind, wobei die genannte zweite Schicht ein Harz umfaßt, welches durch eine dreidimensionale Anordnung von Kohlenstoffasern verstärkt ist, wobei die genannten Kohlenstoffasern zentrifugengesponnene Kohlenstoffasern auf der Basis von Mesophasenpech sind und eine lamellare Struktur, Querschnittsbreiten von 2 bis 12 Mikrometer und Längen von oberhalb 10 mm aufweisen.

2. Gegenstand nach Anspruch 1, bei welchem die genannte elektrische Vorrichtung mit Hilfe eines zweistufigen Spritzgießverfahrens eingekapselt worden ist, wobei das genannte Harz thermoplastisch ist.

## Revendications

1. Un article manufacturé perfectionné comprenant : un dispositif électrique comportant des composants électriquement actifs, lesdits composants étant enrobés par une première couche (20) en une matière électriquement isolante, et une deuxième couche (22) en une matière thermiquement conductrice formant la surface externe dudit article, ladite deuxième couche comprenant une résine renforcée par un arrangement tridimensionnel de fibres de carbone, lesdites fibres de carbone étant des fibres de carbone à base de brai mésophasique filées par centrifugation et ayant une structure lamellaire, des largeurs de section droite de 2 à 12 »m et des longueurs supérieures à 10 mm.

2. L'article de la revendication 1 dans lequel ledit dispositif électrique est enrobé par une processus de moulage par injection en deux temps, ladite résine étant thermoplastique.
